# EUROPEAN PATENT APPLICATION

(11) **EP 4 507 279 A1**
(43) Date of publication of application: **12.02.2025**
(21) Application number: 23803776.6
(22) Date of filing: 08.05.2023
(51) Int. Cl.: H04M 1/02, G06F 1/16, G09F 9/30, H10K 77/10, H10K 50/84

(54) **FLEXIBLE DISPLAY AND ELECTRONIC DEVICE INCLUDING FLEXIBLE DISPLAY**

(30) Priority: 09.05.2022 KR 20220056786; 01.08.2022 KR 20220095600
(71) Applicant: Samsung Electronics Co., Ltd., Suwon-si, Gyeonggi-do 16677 (KR)
(72) Inventor: AN, Jungchul, Suwon-si, Gyeonggi-do 16677 (KR); KIM, Seonghoon, Suwon-si, Gyeonggi-do 16677 (KR); JUNG, Hyunsuk, Suwon-si, Gyeonggi-do 16677 (KR); KIM, Sangkyu, Suwon-si, Gyeonggi-do 16677 (KR)
(74) Representative: HGF
(86) International application number: PCT/KR2023/006200
(87) International publication number: WO 2023/219353

(57) **Abstract**

An electronic device according to various embodiments disclosed in the present document may include: a first housing; a second housing rotatably coupled to the first housing; a display panel of which a partial area is deformed by rotation of the second housing with respect to the first housing; a support plate which is arranged under the display panel to support the display panel and includes a first portion including the deformation area of the display panel and a plurality of openings formed at predetermined intervals, and a second portion excluding the first portion; a first reinforcement plate arranged under the support plate and arranged in the housing such that at least a portion thereof is located in the first portion; and a second reinforcement plate arranged under the support plate and arranged in the second housing such that at least a portion thereof is located in the first portion, wherein the first portion of the support plate includes: a first area in which the openings have a first width therebetween in a first direction; and a second area in which the openings have a second width therebetween in the first direction, the second width being larger than the first width, and of which at least a portion is located between the first reinforcement plate and the second reinforcement plate.

## Description

### [Technical Field]

Various embodiments disclosed herein relate to a flexible display and an electronic device including the same.

### [Background Art]

With the advancement of display technology, electronic devices that are capable of being transformed into various shapes are being provided. For example, a foldable electronic device with two housings that operate by folding or unfolding may be provided. The foldable electronic device may include a flexible display that is foldable together in response to the folding operation of the two housings. In the flexible display, the folding region may require a laminated structure that can be protected from external impacts to the electronic device.

### [Disclosure of Invention]

### [Technical Problem]

An electronic device may operate in a manner in which two housings are folded or unfolded around a folding axis. A display module disposed in the electronic device may include a folding region that is capable of being transformed together in response to the folding or unfolding operation of the electronic device. The display module may include a display panel and a support plate that supports the display panel. The support plate may include multiple openings formed in a region corresponding to the folding region so that the support plate can be smoothly folded or unfolded in the folding region of the display module.

Since the electronic device is folded about a folding axis, the mechanical components disposed below the display module may be separated based with reference to the folding axis. For example, the mechanical components or electronic components disposed under the support plate may be separated with reference to the folding axis and disposed, respectively, in the two housings constituting the electronic device.

Meanwhile, the durability of the folding region of the display module may be reduced due to the structure in which the openings in the support plate located in the folding region of the display module and the mechanical components (or electronic components) disposed below the display module are separated. For example, if the folding region of the display module is pressed, damage to the display module may occur.

Various embodiments disclosed herein present measures to enhance the durability of the folding region of a display module.

### [Solution to Problem]

According to various embodiments disclosed herein, an electronic device may include a first housing, a second housing rotatably connected to the first housing, a display panel a portion of which is transformed by rotation of the second housing relative to the first housing, a support plate disposed below the display panel to support the display panel and including a region where the display panel is transformed, wherein the support plate includes a first portion including multiple openings which are arranged at predetermined intervals(e.g., width), and a second portion excluding the first portion, a first reinforcement plate disposed below the support plate and disposed in the first housing such that at least a portion thereof is located in the first portion, and a second reinforcement plate disposed below the support plate and disposed in the second housing such that at least a portion thereof is located in the first portion. The first portion of the support plate may include a first region in which the width between the openings in a first direction is a first width, and a second region in which the width between the openings in the first direction is a second width wider than the first width, in which at least a portion of the second region is located between the first reinforcement plate and the second reinforcement plate.

According to various embodiments disclosed herein, a display module included in an electronic device including a first housing and a second housing which are rotatably connected to each other may include a display panel a portion of which is transformed by rotation of the second housing relative to the first housing, a support plate disposed below the display panel to support the display panel and including a region where the display panel is transformed, wherein the support plate includes a first portion including multiple openings which are arranged at predetermined intervals, and a second portion excluding the first portion, a first reinforcement plate disposed below the support plate and disposed in the first housing such that at least a portion thereof is located in the first portion, and a second reinforcement plate disposed below the support plate and disposed in the second housing such that at least a portion thereof is located in the first portion. The first portion of the support plate may include a first region in which the interval between the openings in a first direction is a first width, and a second region in which the interval between the openings in the first direction is a second width wider than the first width, in which at least a portion of the second region is located between the first reinforcement plate and the second reinforcement plate.

### [Advantageous Effects of Invention]

In various embodiments disclosed herein, the area of the display module supported via the support plate in the folding region can be increased. Accordingly, the durability of the folding region of the display module can be increased.

### [Brief Description of Drawings]

With regard to the description of the drawings, the same or like reference signs may be used to designate the same or like elements.
FIGS. 1A and 1B are front and rear views of an electronic device according to various embodiments of the disclosure in an unfolded state.
FIGS. 2A and 2B are front and rear views of the electronic device according to various embodiments of the disclosure in a folded state.
FIG. 3 is an exploded perspective view of the electronic device according to various embodiments of the disclosure.
FIG. 4 is an exploded perspective view of a first display according to various embodiments of the disclosure.
FIG. 5A is a schematic cross-sectional view of a display module according to various embodiments disclosed herein.
FIG. 5B is an enlarged view of a portion P1 illustrated in FIG. 5A in which the arrangement relationship between a support plate and a reinforcement plate when the display module is viewed from the front surface of the electronic device.
FIG. 6A is a cross-sectional schematic view of a display module in another embodiment.
FIG. 6B is an enlarged view of a portion P2 illustrated in FIG. 6A in which the arrangement relationship between a support plate and a reinforcement plate when the display module is viewed from the front surface of the electronic device.
FIG. 7A is a cross-sectional schematic view of a display module according to an embodiment different from FIG. 5A.
FIG. 7B is a cross-sectional schematic view of a display module according to an embodiment different from FIG. 6A.
FIG. 8A is a view illustrating a state in which one surface of a support plate constituting a display module according to various embodiments disclosed herein is removed.
FIG. 8B is a view illustrating a state in which one surface of a support plate constituting the display module in an embodiment different from FIG. 8A is removed.

### [Mode for the Invention]

It should be appreciated that the embodiments and the terms used therein are not intended to limit the technological features set forth herein to particular embodiments and the disclosure includes various changes, equivalents, or alternatives for a corresponding embodiment.

With regard to the description of the drawings, similar reference numerals may be used to designate similar or relevant elements. A singular form of a noun corresponding to an item may include one or more of the items, unless the relevant context clearly indicates otherwise.

As used herein, each of such phrases as "A or B," "at least one of A and B," "at least one of A or B," "A, B, or C," "at least one of A, B, and C," and "at least one of A, B, or C" may include all possible combinations of the items enumerated together in a corresponding one of the phrases. Such terms as "a first," "a second," "the first," and "the second" may be used to simply distinguish a corresponding element from another, and does not limit the elements in other aspect (e.g., importance or order). If an element (e.g., a first element) is referred to, with or without the term "operatively" or "communicatively", as "coupled with/to" or "connected with/to" another element (e.g., a second element), it means that the element may be coupled/connected with/to the other element directly (e.g., wiredly), wirelessly, or via a third element.

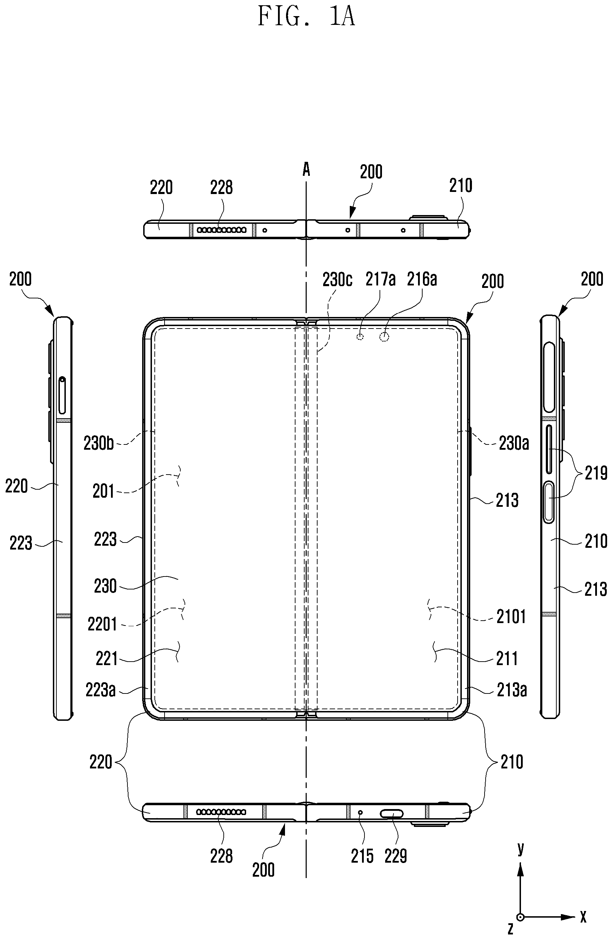

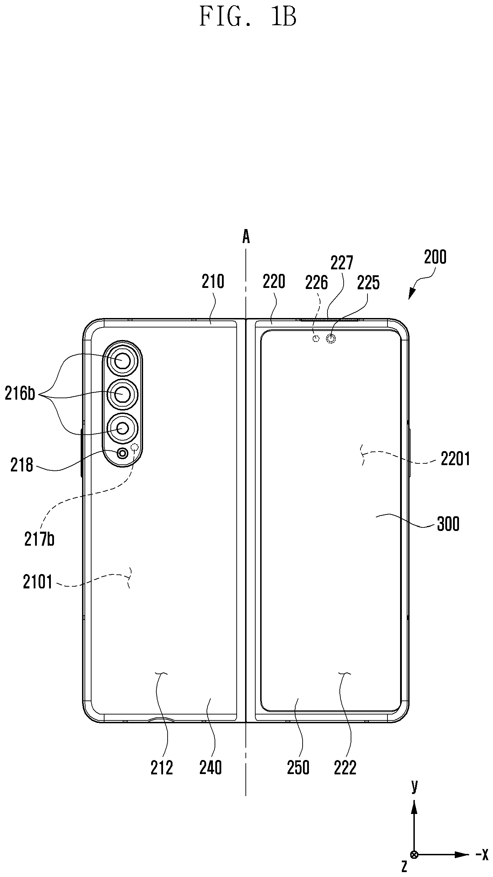

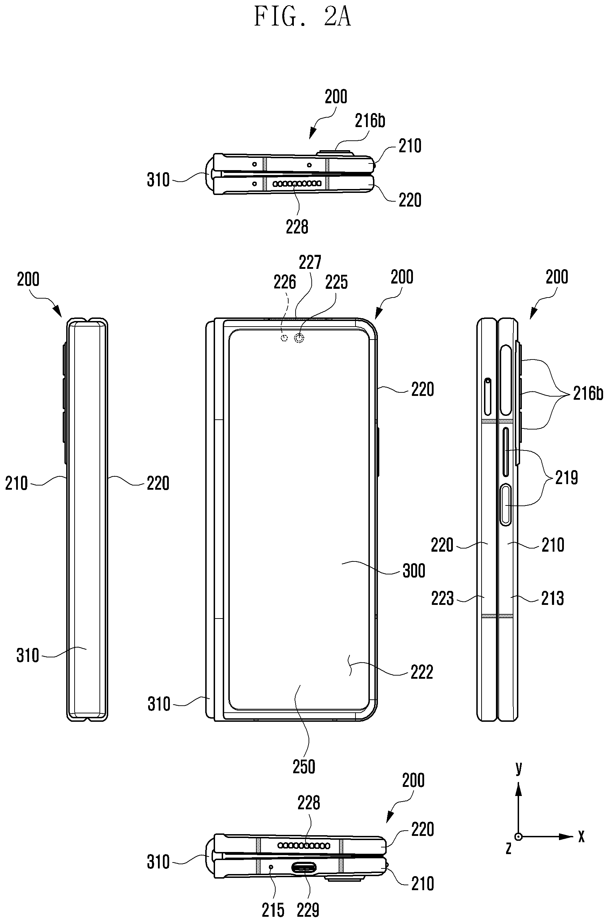

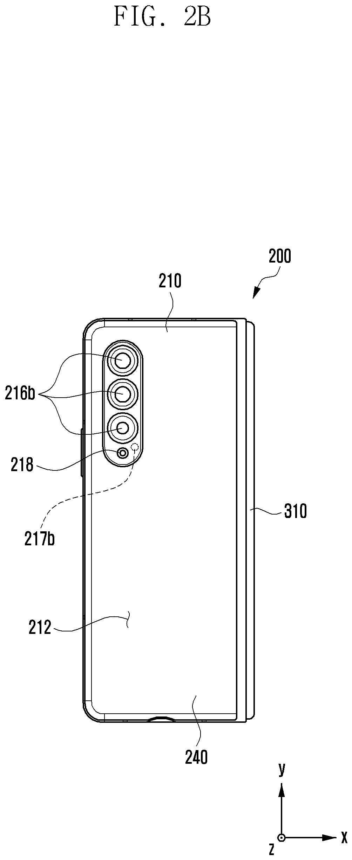

FIGS. 1A and 1B are a front view and a rear view of an electronic device according to various embodiments of the disclosure in an unfolded state. FIGS. 2A and 2B are front and rear views of the electronic device according to various embodiments of the disclosure in a folded state.

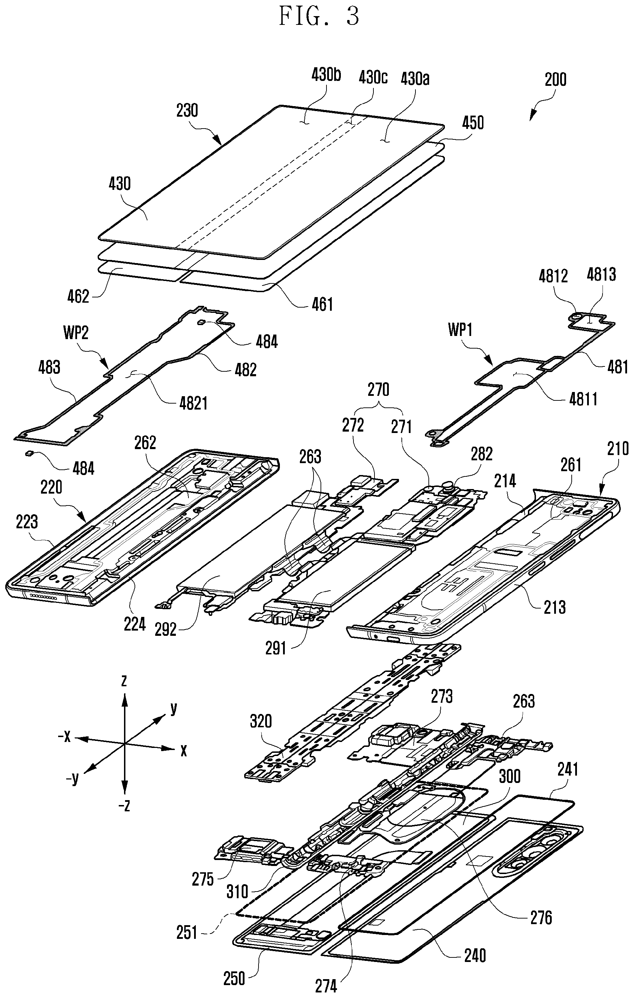

Referring to FIGS. 1A to 2B, an electronic device 200 may include a pair of housings 210 and 220 (e.g., a foldable housing structure) coupled to each other via a hinge device (e.g., the hinge device 320 in FIG. 3) (e.g., a hinge module) to be rotatable about a folding axis A so as to be foldable relative to each other, a first display (e.g., a flexible display, a foldable display, or a main display) disposed on the pair of housings 210 and 220, and/or a second display 300 (e.g., a sub-display) disposed on a second housing 220. According to an embodiment, at least a portion of the hinge device (e.g., the hinge device 320 in FIG. 3) may be disposed to be invisible from the outside through the first housing 210 and the second housing 220, and may be disposed to be invisible from the outside through a hinge housing 310, which covers a foldable portion, in the unfolded state. Herein, the surface on which the first display 230 is disposed may be defined as the front surface of the electronic device 200, and the surface opposite to the front surface may be defined as the rear surface of the electronic device 200. In addition, the surface surrounding the space between the front surface and the rear surface may be defined as the side surface of the electronic device 200.

According to various embodiments, the pair of housings 210 and 220 may include a first housing 210 and a second housing 220 that are disposed to be foldable with respect to each other via the hinge device (e.g., the hinge device 320 in FIG. 3). According to an embodiment, the pair of housings 210 and 220 are not limited to the shape and assembly illustrated in FIGS. 1A to 2B, but may be implemented by other shapes or other combinations and/or assemblies of components. According to an embodiment, the first housing 210 and the second housing 220 may be disposed on opposite sides of a folding axis A and may have shapes that are generally symmetrical to each other with respect to the folding axis A. According to some embodiments, the first housing 210 and the second housing 220 may be folded asymmetrically with respect to the folding axis A. According to an embodiment, the first housing 210 and the second housing 220 may form an angle or have a distance therebetween, which may be variable depending on whether the electronic device 200 is in the unfolded state, in the folded state, or in the intermediate state.

According to various embodiments, in the unfolded state of the electronic device 200, the first housing 210 may include a first surface 211 connected to the hinge device (e.g., the hinge 320 in FIG. 3) and arranged to face the front side of the electronic device 200, a second surface 212 facing away from the first surface 211, and/or a first side surface member 213 surrounding at least a portion of a first space between the first surface 211 and the second surface 212. According to an embodiment, in the unfolded state of the electronic device 200, the second housing 220 may include a third surface 221 connected to the hinge device (e.g., the hinge 320 in FIG. 3) and arranged to face the front side of the electronic device 200, a fourth surface 222 facing away from the third surface 221, and/or a second side surface member 223 surrounding at least a portion of a second space between the third surface 221 and the fourth surface 222. According to an embodiment, the first surface 211 may be oriented in substantially the same direction as the third surface 221 in the unfolded state and may at least partially face the third surface 221 in the folded state. According to an embodiment, the electronic device 200 may include a recess 201 provided to accommodate the first display 230 through structural coupling between the first housing 210 and the second housing 220. According to an embodiment, the recess 201 may have substantially the same size as the first display 230.

According to various embodiments, the hinge housing 310 (e.g., a hinge cover) may be disposed between the first housing 210 and the second housing 220 and disposed to cover a portion (e.g., at least one hinge module) of the hinge device (e.g., the hinge device 320 in FIG. 3) disposed in the hinge housing 310. According to an embodiment, the hinge housing 310 may be covered by a portion of the first housing 210 and the second housing 220 or exposed to the outside, depending on whether the electronic device 200 is in the unfolded state, the folded state, or the intermediate state. For example, when the electronic device 200 is in the unfolded state, at least a portion of the hinge housing 310 may not be substantially exposed by being disposed to be covered by the first housing 210 and the second housing 220. According to an embodiment, when the electronic device 200 is in the folded state, at least a portion of the hinge housing 310 may be exposed to the outside between the first housing 210 and the second housing 220. According to an embodiment, when the electronic device is in the intermediate state in which the first housing 210 and the second housing 220 are folded with a certain angle, the hinge housing 310 may be disposed between the first housing 210 and the second housing 220 to be at least partially exposed to the outside of the electronic device 200. For example, the region of the hinge housing 310 exposed to the outside may be smaller than that in the case where the electronic device is fully folded. According to an embodiment, the hinge housing 310 may include a curved surface.

According to various embodiments, when the electronic device 200 is in the unfolded state (e.g., the state in FIGS. 1A and 1B), the first housing 210 and the second housing 220 form an angle of about 180 degrees therebetween, and the first region 230a, the second region 230b, and the folding region 230c of the first display 230 may be arranged to be oriented in substantially the same direction (e.g., the z-axis direction) while forming the same plane. As another embodiment, when the electronic device 200 is in the unfolded state, the first housing 210 may rotate by an angle of about 360 degrees with respect to the second housing 220 to be folded in the opposite direction such that the second surface 212 and the fourth surface 222 face each other (out-folding type).

According to various embodiment, when the electronic device 200 is in the folded state (e.g., the state in FIGS. 2A and 2B), the first surface 211 of the first housing 210 and the third surface 221 of the second housing 220 may be disposed to face each other. **In** this case, the first region 230a and the second region 230b of the first display 230 may form a narrow angle (e.g., in the range of 0 degrees to about 10 degrees) with respect to each other via the folding region 230c, and may be disposed to face each other. According to an embodiment, at least a portion of the folding region 230c may be transformed into a curved shape with a predetermined curvature. According to an embodiment, when the electronic device 200 is in the intermediate state, the first housing 210 and the second housing 220 may be disposed to form a certain angle therebetween. In this case, the first region 230a and the second region 230b of the first display 230 may form an angle that is greater than that in the folded state and smaller than that in the unfolded state, and the curvature of the folding region 230c may be smaller than that in the folded state and greater than that in the unfolded state. In some embodiments, the first housing 210 and the second housing 220 may form an angle at which the first housing 210 and the second housing 220 can be stopped to form a predetermined folding angle between the folded state and the unfolded state via the hinge device (e.g., the hinge device 320 in FIG. 3) (free stop function). In some embodiments, the first housing 210 and the second housing 220 may be continuously operated while being pressed in the unfolding direction and the folding direction with reference to a predetermined inflection angle via the hinge device (e.g., the hinge device 320 in FIG. 3).

According to various embodiments, the electronic device 200 may include at least one of the following components: one or more displays 230 and 300, input devices 215, sound output devices 227 and 228, sensor modules 217a, 217b, and 226, camera modules 216a, 216b, and 225, key input devices 219, indicators (not illustrated), or connector ports 229, in which the components are disposed on or in the first housing 210 and/or the second housing 220. In some embodiments, at least one of the components may be omitted from the electronic device 200, or at least one other component may be additionally included in the electronic device 200.

According to various embodiments, the one or more displays 230 and 300 may include a first display 230 (e.g., a flexible display) arranged to be supported by the first surface 211 of the first housing 210 to the third surface 221 of the second housing 220 across the hinge device (e.g., the hinge device 320 in FIG. 3), and a second display 300 disposed in the inner space of the second housing 220 to be at least partially visible from the outside through the fourth surface 222. **In** some embodiments, the second display 300 may be disposed in the inner space of the first housing 210 to be visible from the outside through the second surface 212. According to an embodiment, the first display 230 may be mainly used when the electronic device 200 is in the unfolded state, and the second display 300 may be mainly used when the electronic device 200 is in the folded state. According to an embodiment, when the electronic device 200 is in the intermediate state, the electronic device 200 may be controlled such that the first display 230 and/or the second display 300 can be used based on the folding angle between the first housing 210 and the second housing 220.

According to various embodiments, the first display 230 may be disposed in an accommodation space defined by the pair of housings 210 and 220. For example, the first display 200 may be disposed in the recess 201 defined by the pair of housings 210 and 220, and may be disposed to occupy substantially most of the front surface of the electronic device 200 in the unfolded state. According to an embodiment, the first display 230 may include a flexible display, at least a portion of which is transformable into a flat shape or a curved shape. According to an embodiment, the first display 230 may include a first region 230a facing the first housing 210, a second region 230b facing the second housing 220, and a folding region 230c interconnecting the first region 230a and the second region 230b and facing the hinge device (e.g., the hinge device 320 in FIG. 3). **In** an embodiment, the region division of the first display 230 is only an exemplary physical division by the pair of housings 210 and 220 and the hinge device (e.g., the hinge device 320 in FIG. 3), and the first display 230 may display a seamless single entire screen substantially with the pair of housings 210 and 220 and the hinge device (e.g., the hinge device 320 in FIG. 3). According to an embodiment, the first region 230a and the second region 230b may have an overall symmetrical shape or a partially asymmetrical shape with respect to the folding region 230c.

According to various embodiments, the electronic device 200 may include a first rear surface cover 240 disposed on the second surface 212 of the first housing 210 and a second rear surface cover 250 disposed on the fourth surface 222 of the second housing 220. **In** some embodiments, at least a portion of the first rear surface cover 240 may be formed integrally with the first side surface member 213. **In** some embodiments, at least a portion of the second rear surface cover 250 may be formed integrally with the second side surface member 223. According to an embodiment, at least one of the first rear surface cover 240 and the second rear surface cover 250 may be made of a substantially transparent plate (e.g., a glass plate including various coating layers, or a polymer plate) or an opaque plate. According to an embodiment, the first rear surface cover 240 may be made of, for example, coated or colored glass, ceramic, polymer, metal (e.g., aluminum, stainless steel (STS), or magnesium), or an opaque plate such as a combination of two or more of these materials. According to an embodiment, the second rear surface cover 250 may be made of a substantially transparent plate of, for example, glass or polymer. Accordingly, the second display 300 may be disposed in the inner space of the second housing 220 to be visible from the outside through the second rear surface cover 250.

According to various embodiments, the input device 215 may include a microphone. **In** some embodiments, the input devices 215 may include a plurality of microphones disposed to detect the direction of sound. According to an embodiment, the sound output devices 227 and 228 may include speakers. **In** an embodiment, the sound output devices 227 and 228 may include a call receiver 227 disposed through the fourth surface 222 of the second housing 220, and an external speaker 228 disposed through at least a portion of the second side surface member 223 of the second housing 220. **In** some embodiments, the input devices 215, the sound output devices 227 and 228, and the connector ports 229 may be disposed in the spaces of the first housing 210 and/or the second housing 220, and may be exposed to the external environment through one or more holes provided in the first housing 210 and/or the second housing 220. **In** some embodiments, the holes provided in the first housing 210 and/or the second housing 220 may be commonly used for the input device 215 and the sound output devices 227 and 228. **In** some embodiments, the sound output devices 227 and 228 may include a speaker that operates without holes provided in the first housing 210 and/or the second housing 220 (e.g., a piezo speaker).

According to various embodiments, the camera modules 216a, 216b, and 225 may include a first camera module 216a disposed on the first surface 211 of the first housing 210, a second camera module 216b disposed on the second surface 212 of the first housing 210, and/or a third camera module 225 disposed on the fourth surface 222 of the second housing 220. In an embodiment, the electronic device 200 may include a flash 218 located near the second camera module 216b. According to an embodiment, the flash 218 may include, for example, a light-emitting diode or a xenon lamp. According to an embodiment, the camera modules 216a, 216b, and 225 may include one or more lenses, an image sensor, and/or an image signal processor. In some embodiments, at least one of the camera modules 216a, 216b, and 225 may include two or more lenses (e.g., wide-angle and telephoto lenses) and image sensors, and the camera modules may be disposed together on one surface of the first housing 210 and/or the second housing 220.

According to various embodiments, the sensor modules 217a, 217b, and 226 may generate electrical signals or data values corresponding to an internal operating state or an external environmental state of the electronic device 200. According to an embodiment, the sensor modules 217a, 217b, and 226 may include a first sensor module 217a disposed on the first surface 211 of the first housing 210, a second sensor module 217b disposed on the second surface 212 of the first housing 210, and/or a third sensor module 226 disposed on the fourth surface 222 of the second housing 220. In some embodiments, the sensors 217a, 217b, and 226 may include at least one of a gesture sensor, a grip sensor, a color sensor, an infrared (IR) sensor, an illumination sensor, an ultrasonic sensor, an iris recognition sensor, or a distance detection sensor (e.g., a time-of-flight (TOF) sensor or a light detection and ranging (LiDAR)).

According to various embodiments, the electronic device 200 may further include at least one of sensor modules (not illustrated) such as an air pressure sensor, a magnetic sensor, a biometric sensor, a temperature sensor, a humidity sensor, or a fingerprint recognition sensor. In some embodiments, the fingerprint recognition sensor may be disposed through at least one of the first side surface member 213 of the first housing 210 and/or the second side surface member 223 of the second housing 220.

According to various embodiments, the key input devices 219 may be disposed to be exposed to the outside through the first side surface member 213 of the first housing 210. In some embodiments, the key input devices 219 may be disposed to be exposed outside through the second side surface member 223 of the second housing 220. In some embodiments, the electronic device 200 may not include some or all of the above-mentioned key input devices 219, and a key input device 219, which is not included, may be implemented in another form, such as a soft key, on at least one display 230 or 300. As another embodiment, the key input devices 219 may be implemented using pressure sensors included in at least one display 230 or 300.

According to various embodiments, the connector ports 229 may include a connector (e.g., a USB connector or an interface connector port module (IF module)) configured to transmit/receive power and/or data to and from an external electronic device. In some embodiments, the connector ports 229 may further include a separate connector port (e.g., an ear jack hole) for performing a function for transmitting/receiving an audio signal to and from the external electronic device or an audio signal transmitting/receiving function.

According to various embodiments, at least one camera module 216a or 225 among the camera modules 216a, 216b, and 225, at least one sensor module 217a or 226 among the sensor modules 217a, 217b, and 226, and/or an indicator may be disposed to be exposed through the at least one display 230 or 300. For example, the at least one camera module 216a or 225, the at least one sensor module 217a or 226, and/or the indicator may be disposed in the inner space of the at least one housing 210 or 300 below the active region (display region) of the at least one display 230 or 300, and may be disposed to come into contact with the external environment through an opening perforated up to the cover member (e.g., a window layer (not illustrated) of the first display 230 and/or the second rear surface cover 250) or a transparent region. According to an embodiment, a region in which the at least one display 230 or 300 and the at least one camera module 216a or 225 face each other may be provided as a transmission region with a predetermined transmittance as a portion of a content display region. According to an embodiment, the transmission region may have a transmittance ranging from about 5% to about 20%. The transmission region may include a region overlapping the effective region (e.g., a view angle region) of the at least one camera module 216a or 225 through which light imaged by an image sensor to generate an image passes. For example, the transmission region of the display 230 or 300 may include a region having a lower pixel density than the periphery. For example, the transmission region may replace an opening. For example, the at least one camera module 216a or 225 may include an under-display camera (UDC) or an under-panel camera (UPC). As another embodiment, some camera modules or sensor modules 217a and 226 may be arranged to perform the functions thereof without being visually exposed through a display. For example, the regions facing the camera modules 216a and 225 and/or the sensor modules 217a and 226 disposed under the displays 230 and 300 (e.g., a display panel) may have an under-display camera (UDC) structure, and may not require a perforated opening.

FIG. 3 is an exploded perspective view illustrating the electronic device 200 according to various embodiments of the disclosure.

Referring to FIG. 3, the electronic device 200 may include a first display 230 (e.g., a flexible display), a second display 300, a hinge device 400, a pair of support members 261 and 262, at least one board 270 (e.g., a printed circuit board (PCB)), a first housing 210, a second housing 220, a first rear surface cover 240, and/or a second rear surface cover 250.

According to various embodiments, the first display 230 may include a display panel 430 (e.g., a flexible display panel), a support plate 450 disposed below the display panel 430, and a pair of reinforcement plates 461 and 462 disposed below the support plate 450. According to an embodiment, the display panel 430 may include a first panel region 430a corresponding to a first region (e.g., the first region 230a in FIG. 1A) of the first display 230, a second panel region 430b extending from the first panel region 430a and corresponding to a second region (e.g., the second region 230b in FIG. 1) of the first display 230, and a third panel region 430c interconnecting the first panel region 430a and the second panel region 430b and corresponding to a folding region (e.g., the folding region 230c in FIG. 1A) of the first display 230. According to an embodiment, the support plate 450 may be disposed between the display panel 430 and a pair of support members 261 and 262 and may be configured to have a material and a shape to provide a flat support structure for the first panel region 430a and the second panel region 430b and a bendable structure for supporting bendability of the third panel region 430c. According to an embodiment, the support plate 450 may be made of a conductive material (e.g., metal) or a non-conductive material (e.g., polymer or fiber reinforced plastics (FRP)). According to an embodiment, the pair of reinforcement plates 461 and 462 may include, between the support plate 450 and the pair of support members 261 and 262, a first reinforcement plate 461 disposed corresponding to at least a portion of the first panel region 430a and the third panel region 430c, and a second reinforcement plate 462 disposed corresponding to at least a portion of the second panel region 430b and the third panel region 430c. According to an embodiment, the pair of reinforcement plates 461 and 462 may be made of a metal material (e.g., SUS) to help reinforce the ground connection structure and rigidity for the first display 230.

According to various embodiments, the second display 300 may be disposed in the space between the second housing 220 and the second rear surface cover 250. According to an embodiment, the second display 300 may be disposed in the space between the second housing 220 and the second rear surface cover 250 to be visible from the outside through substantially the entire area of the second rear surface cover 250.

According to an embodiment, at least a portion of the first support member 261 may be coupled to the second support member 262 to be foldable via the hinge device 320. According to an embodiment, the electronic device 200 may include at least one wiring member 280 (e.g., a flexible printed circuit board (FPCB) extending from at least a portion of the first support member 261 to a portion of the second support member 262 across the hinge device 320. According to an embodiment, the first support member 261 may extend from the first side surface member 213 or may be disposed in a manner of being structurally coupled with the first side surface member 213. According to an embodiment, the electronic device 200 may include a first space (e.g., the first space 2101 in FIG. 1A) provided by the first support member 261 and the first rear surface cover 240. According to an embodiment, the first housing 210 (e.g., the first housing structure) may be configured through the coupling of the first side surface member 213, the first support member 261, and the first rear surface cover 240. According to an embodiment, the second support member 262 may extend from the second side surface member 223 or may be disposed in a manner of being structurally coupled with the second side surface member 223. According to an embodiment, the electronic device 200 may include a second space (e.g., the second space 2201 in FIG. 1A) provided by the second support member 262 and the second rear surface cover 250. According to an embodiment, the second housing 220 (e.g., the second housing structure) may be configured through the coupling of the second side surface member 223, the second support member 262, and the second rear surface cover 250. According to an embodiment, at least a portion of the at least one wiring member 280 and/or the hinge device 320 may be disposed to be supported by at least a portion of the pair of support members 261 and 262. According to an embodiment, the at least one wiring member 280 may be arranged in a direction across the first support member 261 and the second support member 262 (e.g., in the x-axis direction). According to an embodiment, the at least one wiring member 280 may be arranged in a direction (e.g., the x-axis direction) substantially perpendicular to the folding axis (e.g., the y-axis or the folding axis A1 in FIG. 1).

According to various embodiments, the at least one board 270 may include a first board 271 disposed in the first space 2101 and a second board 272 disposed in the second space 2201. According to an embodiment, the first board 271 and the second board 272 may include a plurality of electronic components disposed thereon to implement various functions of the electronic device 200. According to an embodiment, the first board 271 and the second board 272 may be electrically connected to each other via at least one wiring member 280. In an embodiment, a camera module 282 may be disposed on the first substrate 271.

According to various embodiments, the electronic device 200 may include at least one battery 291 or 292. According to an embodiment, the at least one battery 291 or 292 may include a first battery 291 disposed in the first space 2101 of the first housing 210 and electrically connected to the first board 271 and a second battery disposed in the second space 2201 of the second housing 220 and electrically connected to the second board 272. According to an embodiment, the first support member 261 and the second support member 262 may further include one or more swelling holes for the first battery 291 and the second battery 292.

According to various embodiments, the first housing 210 may include a first rotation support surface 214, and the second housing 220 may include a second rotation support surface 224 corresponding to the first rotation support surface 214. According to an embodiment, the first rotation support surface 214 and the second rotation support surface 224 may each include a curved surface corresponding to (naturally connected to) the curved outer surface of the hinge housing 310. According to an embodiment, when the electronic device 200 is in the unfolded state, the first rotation support surface 214 and the second rotation support surface 224 may cover the hinge housing 310 to prevent the hinge housing 310 from being exposed to the rear surface of the electronic device 200 or to expose only a portion of the hinge housing 310 to the rear surface of the electronic device 200. According to an embodiment, when the electronic device 200 is in the folded state, the first rotation support surface 214 and the second rotation support surface 224 may rotate along the curved outer surface of the hinge housing 310 to at least partially expose the hinge housing 310 to the rear surface of the electronic device 200.

According to various embodiments, the electronic device 200 may include at least one antenna 276 disposed in the first space 2201. According to an embodiment, the at least one antenna 276 may be disposed on the first battery 291 and the first rear surface cover 240 in the first space 2201. According to an embodiment, the at least one antenna 276 may include, for example, a near-field communication (NFC) antenna, a wireless charging antenna, and/or a magnetic secure transmission (MST) antenna. According to an embodiment, the at least one antenna 276 may execute, for example, short-range communication with an external device or wireless transmission/reception of power required for charging. In some embodiments, an antenna structure may be configured by at least a portion of the first side surface member 213 or the second side surface member 223 and/or a portion of the first support member 261 and the second support member 262, or a combination thereof.

According to various embodiments, the electronic device 200 may further include at least one electronic component assembly 274 or 275 and/or additional support members 263 disposed in the first space 2101 and/or the second space 2201. For example, the at least one electronic component assembly may include an interface connector port assembly 274 or a speaker assembly 275.

According to various embodiments, the electronic device 100 may include a first waterproof structure WP1 disposed between the first reinforcement plate 461 and the first support member 261 and a second waterproof structure WP2 disposed between the second reinforcement plate 462 and the second support member 262. According to an embodiment, the first waterproof structure WP1 may include a first waterproof member 481 disposed to form at least one first waterproof space 4811, 4812, or 4813 between the first reinforcement plate 461 and the first support member 261. According to an embodiment, the second waterproof structure WP2 may include a second waterproof member 482, a third waterproof member 483, and a fourth waterproof member 484 disposed to form at least one second waterproof space 4821 between the second reinforcement plate 462 and the second support member 262. According to an embodiment, the fourth waterproof member 484 may be disposed to interconnect stepped and spaced spaces of the second waterproof member 482 and the third waterproof member 483.

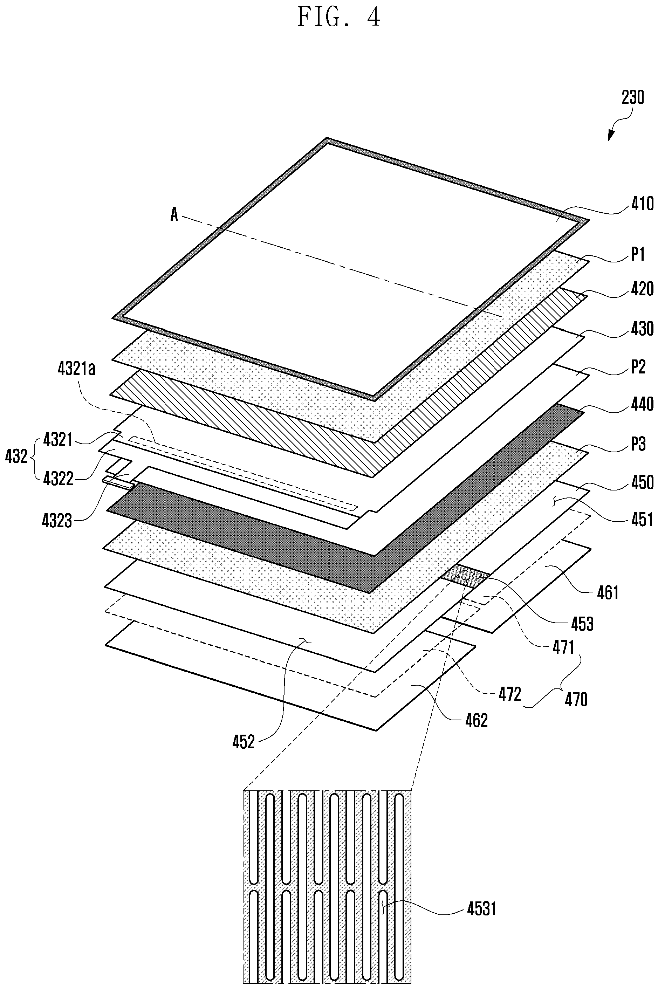

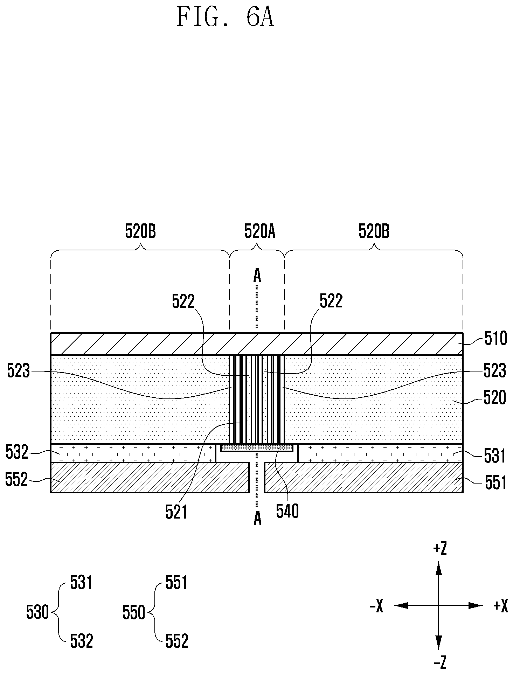

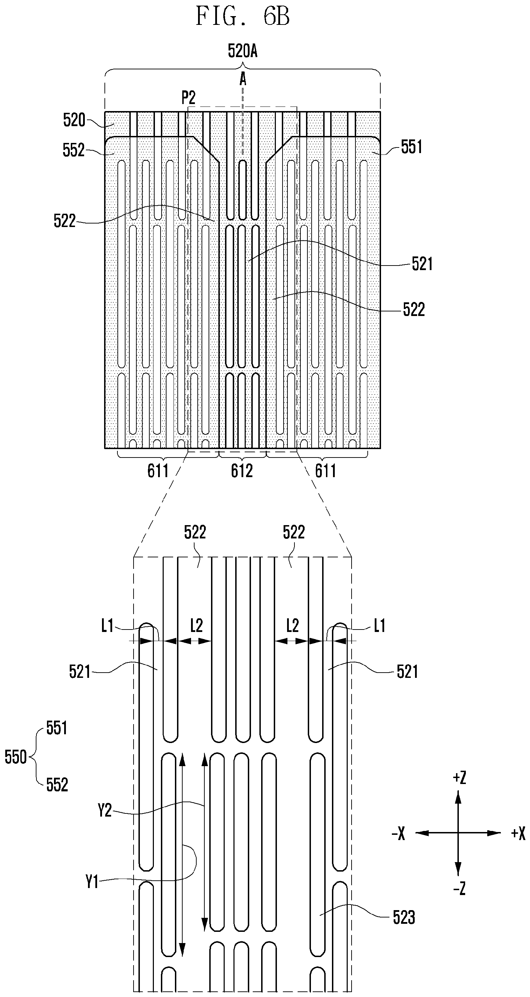

According to various embodiments, the at least one first waterproof space 4811 may be disposed to accommodate a penetration path of a cable member (e.g., the first cable member 4711 in FIG. 6) as a wiring structure for connecting an electronic component (e.g., the first digitizer panel 471 in FIG. 4) disposed between the first reinforcement plate 461 and the first support member 262 to the first space 2101 through the first waterproof member 481. According to an embodiment, the at least one second waterproof space 4821 may be disposed to accommodate a penetration path of a cable member (e.g., the second cable member 4721 in FIG. 6) as a wiring structure for connecting an electronic component (e.g., the second digitizer panel 472 in FIG. 4) disposed between the second reinforcement plate 462 and the second support member 262 to the second space 2201 through the second waterproof member 482, the third waterproof member 483, and the fourth waterproof member 484. According to an embodiment, the at least one first waterproof space 4812 or 4813 may accommodate a region corresponding to at least one electronic component (e.g., a camera module or a sensor module) disposed to be supported by the first support member 261. According to an embodiment, the at least one second waterproof space 4821 may accommodate at least a portion of a bending portion (e.g., the bending portion 432 in FIG. 4) that is folded toward the rear surface of the first display 230. For example, the at least one second waterproof space 4821 may be disposed to surround at least a portion of the bending portion 432 that extends from the display panel (e.g., the display panel 430 in FIG. 4) of the first display 230 and is folded to the rear surface. Accordingly, a control circuit (e.g., the control circuit 4321a in FIG. 4) and multiple electrical elements (not illustrated) disposed in the bending portion 432 may be protected from external moisture and/or foreign substances by being disposed in the at least one second waterproof space 4821.

In the electronic device 200 according to an exemplary embodiment of the disclosure, at least one waterproof member 481, 482, 483, or 484 includes at least one waterproof structure WP1 or WP2 disposed between the first support member 261 and the first reinforcement plate 461 of the first housing 210 and/or between the second support member 262 and the second reinforcement plate 462 of the second housing 220. Therefore, by the phenomenon of the first display being damaged through the waterproof member may be reduced when separating the first display 230 from the housings 210 and 220 for the maintenance of the electronic device 200. In addition, the at least one waterproof member 481, 482, 483, or 484 is disposed to avoid the rear surface of the first display 230, which may improve external visibility and help ensure surface quality.

FIG. 4 is an exploded perspective view of a display module according to various embodiments disclosed herein. The display module in FIG. 4 may be an example of the first display (e.g., the first display 230 in FIGS. 1A and 3) previously described with reference to FIGS. 1A and 3.

The flexible display module 230 according to exemplary embodiments of the disclosure may include an unbreakable (UB)-type OLED display (e.g., a curved display). However, the disclosure is not limited thereto, and the flexible display module 230 may include a flat-type display of an on-cell-touch active-matrix organic light-emitting diode (AMOLED) (OCTA) type.

Referring to FIG. 4, the flexible display module 230 may include a window layer 410, and a polarizer (POL) 420 (e.g., a polarizing film), a display panel 430, a polymer layer 440, a support plate 450, and reinforcement plates 461 and 462, which are sequentially disposed on the rear surface of the window layer 410 (e.g., in the -z-axis direction). In some embodiments, the flexible display module 230 may include a digitizer panel 470 disposed between the support plate 450 and the reinforcement plates 461 and 462. In some embodiments, the digitizer panel 470 may be disposed between the polymer layer 440 and the support plate 450.

According to various embodiments, the window layer 410 may include a glass layer. According to an embodiment, the window layer 410 may include ultra-thin glass (UTG). In some embodiments, the window layer 410 may include a polymer. In this case, the window layer 410 may include polyethylene terephthalate (PET) or polyimide (PI). In some embodiments, the window layer 410 may be arranged in multiple layers to include a glass layer and a polymer.

According to various embodiments, the window layer 410, the polarizer 420, the display panel 430, the polymer layer 440, and the support plate 450 may be disposed to cross at least a portion of the first surface (e.g., the first surface 211 in FIG. 1A) of the first housing (e.g., the first housing 210 in FIG. 1A) and the third surface (e.g., the third surface 221 in FIG. 1A) of the second housing (e.g., the second housing 220 in FIG. 1A). According to an embodiment, the reinforcement plates 461 and 462 may include a first reinforcement plate 461 corresponding to the first housing (e.g., the first housing 210 in FIG. 1A) or a second reinforcement plate 462 corresponding to the second housing (e.g., the second housing 220 in FIG. 1A). According to an embodiment, the reinforcement plates 461 and 462 may provide rigidity for the flexible display module 230 and may be used as a ground to prevent malfunction of the flexible display module 230. According to an embodiment, the reinforcement plates 461 and 462 may be made of a metal material. According to an embodiment, the reinforcement plates 461 and 462 may be made of SUS or Al. According to an embodiment, the window layer 410, the polarizer 420, the display panel 430, the polymer layer 440, the support plate 450, and the reinforcement plates 461 and 462 may be bonded to each other by adhesives P1, P2, and P3 (or a bonding material). For example, the adhesives P1, P2, and P3 may include at least one of an optical clear adhesive (OCA), a pressure-sensitive adhesive (PSA), a heat-responsive adhesive, a general adhesive, and double-sided tape.

According to various embodiments, the display panel 430 may include multiple pixels and a wiring structure (e.g., an electrode pattern). According to an embodiment, the polarizer 420 may selectively allow light, which is generated from a light source of the display panel 430 and vibrates in a predetermined direction, to pass therethrough. According to an embodiment, the display panel 430 and the polarizer 420 may be formed integrally with each other. According to an embodiment, the flexible display module 230 may include a touch panel (not illustrated).

According to various embodiments, the polymer layer 440 may be disposed under the display panel 430 to provide a dark background for securing visibility of the display panel 430, and may be made of a buffering material for a buffering action. In some embodiments, in order to ensure waterproofing of the flexible display module 230, the polymer layer 440 may be removed or disposed under the support plate 450.

According to various embodiments, the support plate 450 may provide a bendable property to the flexible display module 230. For example, the support plate 450 may be made of a non-metallic sheet material, such as fiber reinforced plastics (FRP) (e.g., carbon fiber reinforced plastics (CFRP) or glass fiber reinforced plastics (GFRP)), having a rigid property to support the display panel 430. According to an embodiment, the support plate 450 may include a first flat portion 451 corresponding to the first housing (e.g., the first housing 210 in FIG. 1A), a second flat portion 452 corresponding to the second housing (e.g., the second housing 220 in FIG. 1A), and a bending portion 453 (a flexible portion or a bending portion) interconnecting the first flat portion 451 and the second flat portion 452. According to an embodiment, the bending portion 453 may include multiple openings 4531 arranged at predetermined intervals(e.g., widths). According to an embodiment, the bending property of the bending portion 453 may be determined based on at least one of a size, a shape, or an arrangement density of at least some of the multiple openings 4531. In some embodiments, the support plate 450 may be made of a metal material such as steel use stainless (SUS) (e.g., stainless steel (STS)), Cu, Al, or a metal CLAD (e.g., a laminated member in which SUS and Al are alternately disposed). In this case, throughout the entire area of the support plate 450, the multiple openings may be formed to induce the detection operation of the digitizer panel 470 disposed below the support plate. According to an embodiment, the support plate 450 may help reinforce the rigidity of the electronic device (e.g., the electronic device 200 in FIG. 1A), and may be used to shield ambient noise and dissipate heat emitted from surrounding heat dissipating components.

According to various embodiments, the flexible display module 230 may include a digitizer panel 470 as a detection member disposed under the metal plate 450 and receiving an input of an electronic pen (e.g., a stylus). According to an embodiment, the digitizer panel 470 may include coil members disposed on a dielectric substrate (e.g., a dielectric film or a dielectric sheet) to detect an electromagnetically induced resonance frequency applied by the electronic pen. According to an embodiment, the digitizer panel 470 may include a first digitizer panel 471 corresponding to the first housing (e.g., the first housing 210 in FIG. 1A) and a second digitizer panel 472 corresponding to the second housing (e.g., the second housing 220 in FIG. 1A). According to an embodiment, each of the first digitizer panel 471 and the second digitizer panel 472 is electrically connected to boards (e.g., the boards 271 and 272 in FIG. 3) of an electronic device (e.g., the electronic device 200 in FIG. 3) via a cable member so that the first and second digitizer panels may operate as a single digitizer panel. **In** some embodiments, the first digitizer panel 471 and the second digitizer panel 472 may be operated separately.

According to various embodiments, the flexible display module 230 may include one or more functional members (not illustrated) disposed between the polymer layer 440 and the support plate 450 or below the support plate 450. According to an embodiment, the functional members may include a graphite sheet for heat dissipation, an added display, a force touch FPCB, a fingerprint sensor FPCB, a communication antenna radiator, or conductive/non-conductive tape. According to an embodiment, when the functional members are not bendable, the functional members may be separately disposed in the first housing (e.g., the first housing 210 in FIG. 1A) and the second housing (e.g., the second housing 220 in FIG. 1A). According to an embodiment, when the functional members are bendable, the functional members may be disposed from the first housing (e.g., the first housing 210 in FIG. 1A) to at least a portion of the second housing (e.g., the second housing 220 in FIG. 1A) across the hinge device (e.g., the hinge device 320 in FIG. 3).

According to various embodiments, the flexible display module 230 may include a bending portion 432 disposed in a manner of being folded from the display panel 430 to at least a portion of the rear surface (e.g., -z-axis direction) of the flexible display module 230. According to an embodiment, the bending portion 432 may include an extension 4321 extending from the display panel 430 and including a control circuit 4321a, and a flexible board 4322 electrically connected to the extension 4321 and including multiple electrical elements. According to an embodiment, the control circuit 4321a may include a display driver IC (DDI) or a touch display driver IC (TDDI) mounted on the extension 4321 having an electrical wiring structure. According to an embodiment, the control circuit 4321a may have a chip-on-panel or chip-on-plastic (COP) structure disposed directly on the extension 4321. In some embodiments, the control circuit 4321a may have a chip-on-film (COF) structure mounted on a separate connection film (not illustrated) interconnecting the extension portion 4321 and the flexible board 4322. According to an embodiment, the flexible display module 230 may include multiple electrical elements (not illustrated) disposed on the flexible board 4322. According to an embodiment, the flexible display module 230 may include a cable member 4323 extending from the flexible board 4322 and electrically connected to a board (e.g., the second board 272 in FIG. 3) of the electronic device (e.g., the electronic device 200 of FIG. 3). According to an embodiment, the multiple electrical elements may include passive elements such as a touch IC, a display flash memory, an ESD prevention diode, a pressure sensor, a fingerprint sensor, or a decap. In another embodiment, when the bending portion 432 is disposed in a region of the flexible display module 230 facing the first housing (e.g., the first housing 210 in FIG. 1A), the cable member 4323 may be electrically connected to another board (e.g., the first board 271 in FIG. 3) of the electronic device (e.g., the electronic device 200 in FIG. 3).

According to exemplary embodiments of the disclosure, the electronic device (e.g., the electronic device 200 in FIG. 3) may include a waterproof structure provided to protect regions, which correspond to at least one electronic component (e.g., a camera module or sensor module) disposed via a wiring structure of a cable member extending out from the digitizer panel 470 disposed on the rear surface of the flexible display module 230, at least a portion (the extension 4321) of the bending portion 432 bent to the rear surface of the flexible display module 230 and including the control circuit 4321a and multiple electric elements, and support members 461 and 462, from external moisture and/or foreign substances.

The display module 230 described above is only an example for describing the disclosure, and the display module 230 does not necessarily include all of the components described above. Accordingly, it may be possible to configure the display module 230 by omitting some of the components described above or adding some of the components.

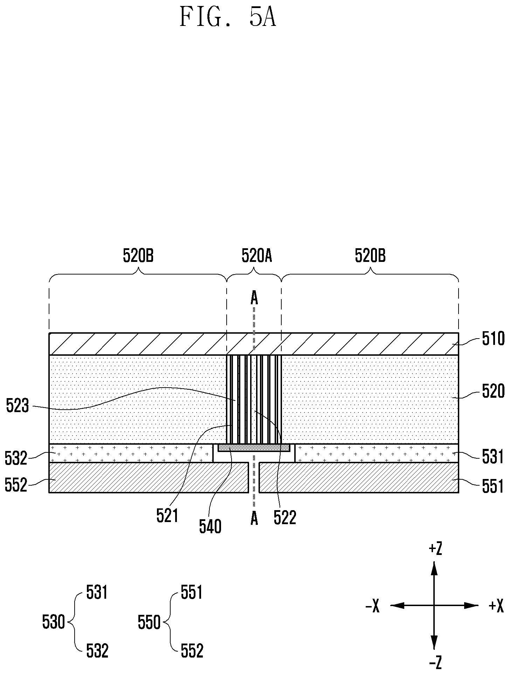

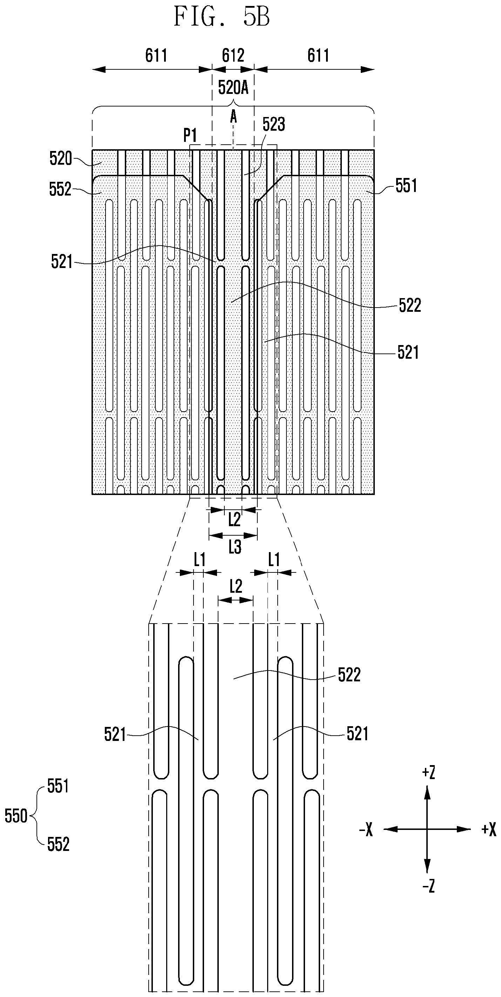

FIG. 5A is a schematic cross-sectional view of a display module according to various embodiments disclosed herein. FIG. 5B is an enlarged view of a portion P1 illustrated in FIG. 5A in which the arrangement relationship between a support plate and a reinforcement plate when the display module is viewed from the front surface of the electronic device is illustrated. FIG. 6A is a cross-sectional schematic view of a display module in another embodiment. FIG. 6B is an enlarged view of a portion P2 illustrated in FIG. 6A in which the arrangement relationship between a support plate and a reinforcement plate when the display module is viewed from the front surface of the electronic device is illustrated.

The display module 500 described below may include at least one of the components of the display module 230 described with reference to FIG. 4. However, the display module may include a structure (e.g., a stacked structure) different from that of the display module 230 described with reference to FIG. 4.

FIG. 5A is merely a schematic view for convenience of description of various embodiments disclosed herein. The display module 500 may further include other components in addition to the components of the display module 230 illustrated in FIG. 4. In addition, the size relationship between the components illustrated in FIG. 5A is not limited to that illustrated in FIG. 5A unless specifically described otherwise.

According to various embodiments, the display module 500 may include a folding region 230c capable of being transformed together with the electronic device 200 when the electronic device 200 is folded or unfolded. In an embodiment, when the electronic device 200 is in the unfolded state, the first housing 210 and the second housing 220 form an angle of about 180 degrees, and the first region 230a, the second region 230b, and the folding region 230c of the first display 230 may be located on the same plane. In an embodiment, when the electronic device 200 is in the folded state or the intermediate state, the folding region 230c may be transformed into a curved shape with a predetermined curvature.

According to various embodiments, the display module 500 may include a display panel 510 (e.g., the display panel 430 in FIG. 4), a support plate 520 (e.g., the support plate 450 in FIG. 4), a cushion layer 530, a foreign substance blocking member 540, and a reinforcement plate 550 (e.g., the reinforcement plates 461 and 462 in FIG. 4).

According to various embodiments, the display panel 510 may include multiple light-emitting devices (e.g., organic light-emitting diodes (OLEDs)) to display visual information, and thin film transistors (TFTs) connected to the light-emitting devices. The display panel 510 may be formed such that at least some regions are transformable. Depending on the rotation (e.g., the folding of the first housing and the second housing) of a first housing (e.g., the first housing 210 in FIG. 1A) and a second housing (e.g., the second housing 220 in FIG. 1A), the portion of the display panel 510 disposed between the first housing and the second housing may be transformed. The board included in the display panel 510 may be made of a flexible material such that the display panel 510 is transformable. For example, the substrate of the display panel 510 may be made of a polymer material such as polyethylene terephthalate (PET) or poly imide (PI).

According to various embodiments, the support plate 520 may be disposed on the rear surface of the display panel 510 to support the display panel 510. For example, the support plate 520 may be made of a non-metallic sheet material, such as fiber reinforced plastics (FRP) (e.g., carbon fiber reinforced plastics (CFRP) or glass fiber reinforced plastics (GFRP)), having a rigid property to support the display panel 510. In an embodiment, the support plate 520 may include a first portion 520A (e.g., the bending portion 453 in FIG. 4) formed to be relatively easily transformed compared to other portions in order to support the display panel 510, which is transformed by folding of the first housing and the second housing. The first portion 520A may be a region including a portion where the display panel 510 is transformed (e.g., the portion between the first housing and the second housing). For example, the first portion 520A may be wider than the portion where the display panel 510 is transformed. In addition, the first portion 520A may be a region including the folding region 230c of the display module 500. In the following description, the support plate 520 will be described by dividing it into a first portion 520A and a second portion 520B. The first portion 520A may include the part where the display panel 510 is transformed, and the second portion 520B can be understood as the remaining region of the support plate 520 excluding the first portion 520A. In an embodiment, multiple openings 521 (e.g., the openings 4531 in FIG. 4) may be provided in the first portion 520A at predetermined intervals (e.g., widths). The transformation characteristics of the support plate 520 may be determined by adjusting at least one of the sizes, shapes, arrangement, or densities of the multiple openings 521. Due to the multiple openings 521, the first portion 520A may have, for example, a lattice shape. Due to the multiple openings 521 provided in the first portion 520A, the first portion 520A may have a relatively flexible characteristic compared to the second portion 520B. In some embodiments, the thickness of the support plate 520 in the first portion 520A may be smaller than the thickness of the support plate 520 in the second portion 520B so as to facilitate the transformation of the first portion 520A. In this case, the first portion 520A may not include the multiple openings 521. In an embodiment, the support plate 520 may be made of a metal material such as steel use stainless (SUS) (e.g., stainless steel (STS)), Cu, Al, or a metal CLAD (e.g., a laminated member in which SUS and Al are alternately disposed). The support plate 520 made of a metal material may help reinforce the rigidity of the electronic device (e.g., the electronic device 200 in FIG. 1), and may be used to shield ambient noise and dissipate heat emitted from surrounding heat dissipating components.

According to various embodiments, the cushion layer 530 may be disposed on the rear surface of the support plate 520. Since the reinforcement plate 550 is disposed on the rear surface of the cushion layer 530, the cushion layer 530 may be disposed between the support plate 520 and the reinforcement plate 550. In an embodiment, the cushion layer 530 may be made of a material that is capable of buffering an external impact applied to the display module 500. The cushion layer 530 may include a porous foam material (e.g., sponge) to be deformed by an external force to buffer the impact. In addition, the cushion layer 530 may include various materials that are capable of buffering an external force. The external force applied to the display module 500 can be buffered by the cushion layer 530, thereby improving the rigidity of the display.

According to various embodiments, the foreign substance blocking member 540 may be disposed on the rear surface of the support plate 520. The foreign substance blocking member 540 may be disposed on the rear surface of the support plate 520 at a position corresponding to the first portion 520A of the support plate 520. In some embodiments, a portion of the foreign substance blocking member 540 may be disposed up to the second portion 520B of the support plate 520. The description that the foreign substance blocking member 540 is disposed on the first portion 520A may be understood to mean that the main portion of the foreign substance blocking member 540 is disposed in the first portion 520A of the support plate 520. The first portion 520A of the support plate 520 may be covered by the foreign substance blocking member 540. The foreign substance blocking member 540 may cover the openings 521 formed in the first portion 520A of the support plate 520 to block external foreign substances that may be introduced through the openings 521. The foreign substance blocking member 540 may be made of a stretchable material so that it can be disposed on the first portion 520A of the support plate 520, which is transformed depending on the folding of the first housing and the second housing. For example, the foreign substance blocking member 540 may be made of elastomer that is a polymer material with elasticity. In some embodiments, the foreign substance blocking member 540 may include thermoplastic polyurethane (TPU). As illustrated in FIG. 5A, the foreign substance blocking member 540 and the cushion layer 530 may be disposed on the rear surface of the support plate 520. The foreign substance blocking member 540 may be disposed at a position corresponding to the first region 520A of the support plate 520, and the cushion layer 530 may be disposed at a position corresponding to the first region 520A of the support plate 520. In an embodiment, the thicknesses of the foreign substance blocking member 540 and the cushion layer 530 may differ from each other. For example, the thickness of the foreign substance blocking member 540 may be smaller than the thickness of the cushion layer 530. In an embodiment, the foreign substance blocking member 540 and the cushion layer 530 may be made of different materials. In some embodiments, the foreign substance blocking member 540 and the cushion layer 530 may be formed integrally.

According to various embodiments, the reinforcement plate 550 may be disposed below the support plate 520 (e.g., in the -Z direction with reference to the support plate 520 illustrated in FIG. 5A). The reinforcement plate 550 may include a first reinforcement plate 551 disposed in the first housing 210 and a second reinforcement plate 552 disposed in the second housing 220. The first reinforcement plate 551 and the second reinforcement plate 552 may be disposed on the rear surface of the cushion layer 530. The first reinforcement plate 551 may be disposed on the rear surface of the first cushion layer 531 (e.g., the surface oriented in the -Z direction with reference to FIG. 5A), and the second reinforcement plate 552 may be disposed on the rear surface of the second cushion layer 532. The reinforcement plate 550 may provide rigidity for the display module 500 and may be used as a ground to prevent malfunction of the display module 500. In an embodiment, the reinforcement plate 550 may be made of a metal material. For example, the reinforcement plate 550 may be made of SUS or Al.

According to various embodiments, various components may be disposed on the rear surface of the reinforcement plate 550. For example, a waterproof member (e.g., the waterproof structures WP1 and WP2 in FIG. 3) and a shielding member 580 may be disposed on the rear surface of the reinforcement plate 550. The waterproof member may be a component for blocking moisture and foreign substances from flowing into the electronic device 200 from the outside. The waterproof member may include an adhesive material. A waterproof space may be formed by a portion surrounded by the waterproof member. Since the waterproof space formed by the waterproof member has a low risk of external moisture penetration, electrical components may be disposed in this portion to be protected from external moisture.

According to various embodiments, some of the components included in the display module 500 may be separated with reference to the folding axis A-A to allow the electronic device 200 to be folded or unfolded smoothly around the folding axis A-A, and may be respectively placed in the first housing 210 or the second housing 220. In an embodiment, a plurality of reinforcement plates 550 may be disposed below the support plate 520 that supports the display panel 510 and may be disposed in the first housing 210 and the second housing 220, respectively. For example, the first reinforcement plate 551 may be disposed below the support plate 520, and may be disposed in the first housing 210 such that at least a portion is located in the first portion 520A of the support plate 520. The second reinforcement plate 552 may be disposed below the support plate 520, and may be disposed in the second housing 220 such that at least a portion is located in the first portion 520A of the support plate 520. Meanwhile, as mechanical components (e.g., the reinforcement plate 550) and electronic components disposed below the display module 500 are disposed separately in the first housing 210 and the second housing 220, durability of the display module 500 may be reduced in the folding region 230c. For example, when pressing the region of the folding region 230c of the display module 500 corresponding to the space between the first reinforcement plate 551 and the second reinforcement plate 552, damage to the display module 500 may occur since there is no mechanical component supporting the region of the display module 500 corresponding to the space between the first reinforcement plate 551 and the second reinforcement plate 552. In addition, openings 523 formed in the first portion 520A of the support plate 520 may be located in the folding region 230c of the display module 500. Accordingly, the folding region 230c of the display module 500 may be less durable than the first region 521 or the second region 522 of the display module 500 supported by the second portion 520B of the support plate 520. In various embodiments disclosed herein, a structure that reinforces the durability of the folding region 230c of the display module 500 may be presented. For example, the area of the support plate 520 that supports a region corresponding to the region between the reinforcement plates 550 in the folding region 230c of the display module 500 may be increased. In this case, the durability of the folding region 230c of the display module 500 may be improved. This will be described in detail later.

According to various embodiments, as illustrated in FIGS. 5A and 5B, the support plate 520 may have varying intervals (e.g., widths) between the openings 523 formed in the first portion 520A. Hereinafter, the first portion 520A of the support plate 520 will be divided and described based on the intervals between the openings 523 formed in the first portion 520A. In addition, for convenience of description, the following description will be made on the premise that the interval between the openings 523 to be described below is an interval (e.g., width) in the first direction (e.g., the X-axis direction with reference to FIG. 6B). The first portion 520A of the support plate 520 may include a first region 521 and a second region 522. Referring to FIG. 5B, the first region 521 of the support plate 520 may be a region where the interval between the openings 523 formed in the first portion 520A is a first width (e.g., first interval) L1. For example, the first region 521 may be a region where the interval between the openings 523 in the first direction (e.g., the X-axis direction with reference to FIG. 6B) is the first width L1. In other words, the first region 521 may be a region of which the width (e.g., the length in the X-axis direction with reference to FIG. 6B) is equal to the first width L1. The second region 522 of the support plate 520 may be a region where the interval between the openings 523 formed in the first portion 520A is a second width (e.g., second interval) L2 wider than the first width L1. For example, the second region 522 may be a region where the interval (e.g., width) between the openings 523 in the first direction is the second width L2. In other words, the second region 522 may be a region of which the width is equal to the second width L2.

In an embodiment, as described above, the support plate 520 is disposed on the rear surface of the display panel 510 (e.g., the surface oriented in the -Z direction with reference to FIG. 5A) to support the display panel 510. Since the first region 521 and the second region 522 of the support plate 520 have different widths, the areas supporting the display panel 510 may be different from each other. For example, since the second region 522 of the support plate 520 has a wider width than the first region 521, the area of the second region supporting the display panel 510 may be wider than the first region 521. Accordingly, the display module 500 may have higher durability in the region supported by the second region 522 of the support plate 520 than in the region supported by the first region 521 of the support plate 520.

According to various embodiments, as illustrated in FIG. 5B, the first portion 520A of the support plate 520 may include a first section 611 corresponding to the first reinforcement plate 551 and the second reinforcement plate 552, and a second section 612 excluding the first section 611. The first section 611 may be the section in which the first portion 520A of the support plate 520 overlaps the first reinforcement plate 551 and/or the second reinforcement plate 552 when the support plate 520 is viewed from the front surface of the electronic device 200 (e.g., in the -Z direction with reference to FIG. 5A). The second section 612 may be the section corresponding to the space between the first reinforcement plate 551 and the second reinforcement plate 552. However, the first section 611 and the second section 612 constituting the first portion 520A of the support plate 520 are intended to explain the positional relationship between the support plate 520 and the reinforcement plate 550 only, and the support plate 520 may not be physically divided into the first section 611 and the second section 612.

According to various embodiments, when viewed from the front surface of the electronic device 200, at least a portion of the second region 522 of the support plate 520 may be located between the first reinforcement plate 551 and the second reinforcement plate 552. In an embodiment, referring to FIGS. 5A and 5B, the second region 522 of the support plate 520 may be located to be included between the first reinforcement plate 551 and the second reinforcement plate when viewed from the front surface of the electronic device 200. For example, the second region 522 of the support plate 520 may be located in the second section 612 and may be located between the first reinforcement plate 551 and the second reinforcement plate 552. Accordingly, the display module 500 may have improved durability by being supported through the second region 522, which is wider than the first region 521, in the region corresponding to the space between the first reinforcement plate 551 and the second reinforcement plate 552. In another embodiment, referring to FIGS. 6A and 6B, which will be described later, the second region 522 of the support plate 520 may be located between the first section 611 and the second section 612. In this case, when the support plate 520 is viewed from the front surface of the electronic device 200 (e.g., in the -Z direction with reference to FIG. 5A), the second region of the support plate may be located to overlap each of one end of the first reinforcement plate 551 and one end of the second reinforcement plate 552. Accordingly, the display module 500 may have improved durability by being supported through the second region 522, which is wider than the first region 521, in the regions corresponding to the one end of the first reinforcement plate 551 and the one end of the second reinforcement plate 552.

In an embodiment, referring to FIG. 5B, the first reinforcement plate 551 and the second reinforcement plate 552 may at least partially overlap the first portion 520A of the support plate 520 when the display module 500 is viewed from the front surface of the electronic device 200. Referring to FIG. 5B, the first reinforcement plate 551 may be disposed in the first housing 210 such that at least a portion thereof is located in the first portion 520A of the support plate 520. The second reinforcement plate 552 may be disposed in the second housing 220 such that at least a portion thereof is located in the first portion 520A of the support plate 520. In an embodiment, the first reinforcement plate 551 and the second reinforcement plate 552 may be disposed in the first housing 210 and the second housing 220, respectively, so as to be symmetrical with respect to the folding axis A-A of the electronic device 200. In one embodiment, the interval between the one end of the first reinforcement plate 551 and the folding axis A-A of the electronic device 200 in the first direction may be equal to the interval between the one end of the second reinforcement plate 552 and the folding axis A-A of the electronic device 200. For example, the center point of the third width (e.g., third interval) L3, which is the interval between the one end of the first reinforcement plate 551 and the one end of the second reinforcement plate 552, may be aligned with the folding axis A-A.

In an embodiment, the second region 522 of the support plate 520 may be located between the first reinforcement plate 551 and the second reinforcement plate 552. Referring to FIG. 5B, the center of the second region 522 of the support plate 520 may be aligned with the folding axis A-A of the electronic device 200. Here, the center of the second region 522 of the support plate 520 may be the center point of the second width L2, which is the width of the second region 522. As being aligned with the folding axis A-A of the electronic device 200, the center of the second region 522 of the support plate 520 may also be aligned with the center of the interval L3 between the first reinforcement plate 551 and the second reinforcement plate 552. According to various embodiments disclosed herein, the second region 522 of the first portion 520A of the support plate 520 may be located between the first reinforcement plate 551 and the second reinforcement plate 552. The second region 522 of the support plate 520 may be formed to have a relatively wider interval than the first region 521 in the first direction (e.g., the X-axis direction with reference to FIG. 5B). In this case, the area supporting the region corresponding to the region between the reinforcement plates 550 in the folding region 230c of the display module 500 may be increased. Accordingly, when an external force is applied to a region of the display module 500 corresponding to the region between the reinforcement plates 550, the phenomenon of damage to the display module 500 may be alleviated or eliminated.

According to various embodiments, as the second width L2 in the second region 522 of the support plate 520 becomes wider, the folding stress that interrupts the folding operation of the support plate 520 may increase. To alleviate this phenomenon, the second region 522 of the support plate 520 may have an interval of a predetermined width or less. In an embodiment, referring to FIG. 5B, the second width L2 of the second region 522 of the support plate 520 may be narrower than the interval L3 between the first reinforcement plate 551 and the second reinforcement plate 552. In this case, the folding stress that may occur in the first portion 520A (e.g., the second region 522) of the support plate 520 due to the folding operation of the electronic device 200 may be reduced when the second width L2 of the second region 522 is wider than the third width between the reinforcement plates 550. Accordingly, the display module 500 (e.g., the support plate 520) may be smoothly folded in response to the folding operation of the electronic device 200.

According to various embodiments, as illustrated in FIGS. 6A and 6B, the second region 522 of the support plate 520 may be located to overlap each of the one end of the first reinforcement plate 551 and the one end of the second reinforcement plate 552 when the support plate 520 is viewed from the front surface of the electronic device 200 (e.g., the -Z direction with reference to FIG. 6A). In one embodiment, the second region 522 of the support plate 520 may be located between the first section 611 and the second section 612 of the first portion 520A, and may be located so as to overlap each of the one end of the first reinforcement plate 551 and the one end of the second reinforcement plate 552. In this case, the second region 522, which is wider than the first region 521 of the support plate 520, may overlap the one ends of the reinforcement plates 550. Accordingly, the area in which the display module 500 is supported by the support plate 520 in the region corresponding to the one ends of the reinforcement plates 550 may be increased. Accordingly, when an external force is applied to a region of the display module 500 corresponding to the region corresponding to the one ends of the reinforcement plates 550, the phenomenon of damage to the display module 500 may be alleviated or eliminated.

According to various embodiments, the sizes of the multiple openings 523 formed in the first portion 520A of the support plate 520 may be different from each other. In an embodiment, referring to FIG. 6B, the length Y2 of the openings 523 located in the second section 612 of the support plate 520 in a second direction (e.g., the Y-axis direction length based on FIG. 6B) may be formed shorter than the length Y1 of the openings 523 located in the first section 611 of the support plate 520 the second direction. In this case, the area in which the openings 523 are not formed may increase in the second section 612 of the support plate 520. Accordingly, the area in which the display module 500 is supported by the support plate 520 in the region corresponding to the space between the reinforcement plates 550 may be increased. Accordingly, the display module 500 may have improved durability in the region corresponding to the space between the reinforcement plates.

Although not illustrated in the drawing, the openings 523 formed in the first section 611 and the second section 612 of the support plate 520 may have different lengths in the first direction (e.g., the lengths in the X-axis direction with reference to FIG. 6B). In an embodiment, the length of the openings 523 located in the second section 612 in the first direction may be smaller than the length of the openings 523 located in the first section 611 in the first direction. In this case, the area in which the openings 523 are not formed may increase in the second section 612 of the support plate 520. Accordingly, the area in which the display module 500 is supported by the support plate 520 in the region corresponding to the space between the reinforcement plates 550 may be increased. Accordingly, when an external force is applied to a region of the display module 500 corresponding to the region between the reinforcement plates 550, the phenomenon of damage to the display module 500 may be alleviated or eliminated. In contrast, the length of the openings 523 located in the first section 611 of the support plate 520 in the first direction may be greater than the length of the openings 523 located in the second section 612 in the first direction. In this case, since the openings 523 have wide areas, the flexibility of the support plate 520 may be increased in the first section 611. Accordingly, the support plate 520 may be smoothly folded or unfolded in response to the folding operation of the electronic device 200.

According to various embodiments, the support plate 520 may be formed such that the arrangement pattern of the openings 523 differs between the first section 611 and the second section 612. In an embodiment, referring to FIG. 6B, in the first section 611 of the support plate 520, the multiple openings 523 may form a first pattern. In the second section 612 of the support plate 520, the multiple openings 523 may form a second pattern. For example, referring to FIG. 6B, the first pattern formed in the first section 611 of the support plate 520 may be a pattern in which the openings 523 with the same size are arranged in a staggered manner. For example, the first pattern may be a pattern in which, among the openings 523 located in the first section 611, adjacent openings are not aligned in the X-axis direction with reference to FIG. 6B. As the openings 523 of the first section 611 of the support plate 520 is formed in the first pattern, the flexibility of the first portion 520A of the support plate 520 may be increased. Accordingly, the support plate 520 may be smoothly folded or unfolded in response to the folding operation of the electronic device 200. In contrast, the second pattern formed in the second section 612 of the support plate 520 may be a pattern in which the openings 523 with the same size are arranged side by side in the X-axis direction with reference to FIG. 6B. As the openings 523 in the second section 612 of the support plate 520 are formed in the second pattern, the area where the display module 500 is supported by the support plate 520 may be increased in the region corresponding to the space between the reinforcement plates 550. Accordingly, the display module 500 may be improved in durability since the area supported by the support plate 520 is increased in the region corresponding to the space region between the reinforcement plates 550.

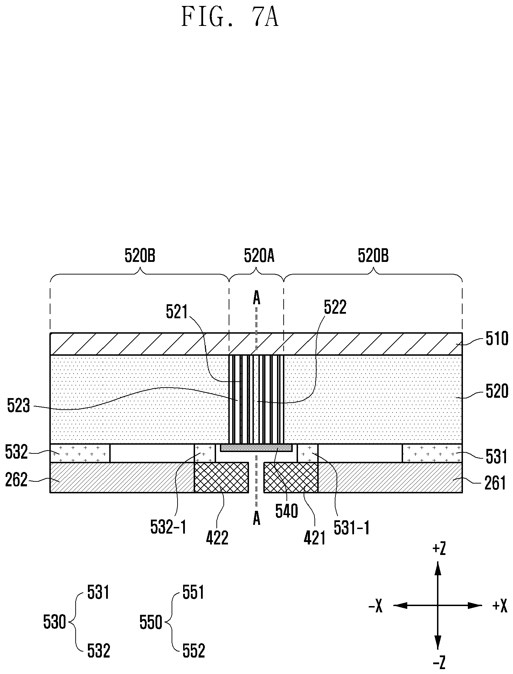

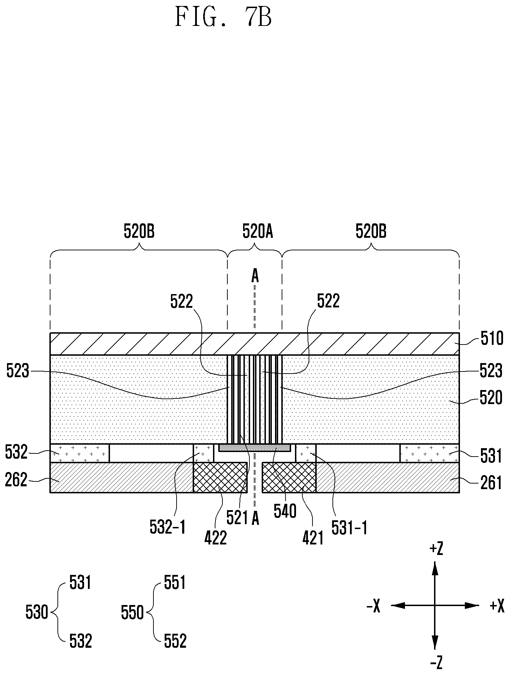

In contrast, FIG. 7A is a cross-sectional schematic view of a display module according to an embodiment different from FIG. 5A. FIG. 7B is a cross-sectional schematic view of a display module according to an embodiment different from FIG. 6A.

Embodiments illustrated in FIGS. 7A and 7B described below may include configurations that are the same as or similar to those of the embodiments previously described with reference to FIGS. 5A to 6B. Descriptions of the same or similar configurations may be omitted, and the configurations different from those described with reference to FIGS. 5A to 6B will be described.

According to various embodiments, as illustrated in FIGS. 7A and 7B, a pair of support members 261 and 262 may be disposed below the support plate 450. The pair of support members 261 and 262 may provide rigidity for the display module 500. The pair of support members 261 and 262 may support the support plate 450 below the support plate 450.

In an embodiment, referring to FIGS. 7A and 7B, a portion of the hinge device 420 may be disposed on the rear surface of the support plate 450 (e.g., the surface oriented in the - Z direction with reference based on FIG. 7A). The hinge device 420 may be located between a pair of support members 261 and 262 below the support plate 450. The hinge device 420 may include a first hinge plate 421 coupled to the first housing 210 and a second hinge plate 422 coupled to the second housing 220. The first hinge plate 421 and the second hinge plate 422 may form substantially the same plane as the first housing 210 and the second housing 220 when the electronic device 200 is in the unfolded state, thereby supporting the display module 230. In addition, the first housing 210 and the second housing 220 may rotate in the state of being coupled to the first hinge plate 421 and the second hinge plate 422.

According to various embodiments, as illustrated in FIGS. 7A and 7B, a plurality of cushion layers 531, 531-1, 532, and 532-1 may be disposed on the rear surface of the support plate 450. Since the reinforcement plate 550 is disposed on the rear surfaces of the cushion layers 531, 531-1, 532, and 532-1, the cushion layers 530 may be disposed between the support plate 520 and the reinforcement plates 550.

In an embodiment, since the first support member 261 is disposed on the rear surface of the first cushion layer 531, the first cushion layer 531 may be located between the first support member 261 and the support plate 450. In addition, since the second support member 262 is disposed on the rear surface of the second cushion layer 532, the second cushion layer 532 may be located between the second support member 262 and the support plate 450.

A (1-1)^{th} cushion layer 531-1 may be disposed between the first hinge plate 421 and the support plate 450. The (1-1)^{th} cushion layer 531-1 may be disposed to be spaced apart from the first cushion layer 531 on the rear surface of the support plate 450. A (2-1)^{th} cushion layer 532-1 may be disposed between the second hinge plate 422 and the support plate 450. The (2-1)^{th} cushion layer 532-1 may be disposed to be spaced apart from the second cushion layer 532 on the rear surface of the support plate 450. A foreign substance blocking member 540 may be located between the (1-1)^{th} cushion layer 531-1 and the (2-1)^{th} cushion layer 532-1. The (1-1)^{th} cushion layer 531-1 and the (2-1)^{th} cushion layer 532-1 may be segmented around the rotation axis A-A of the electronic device.

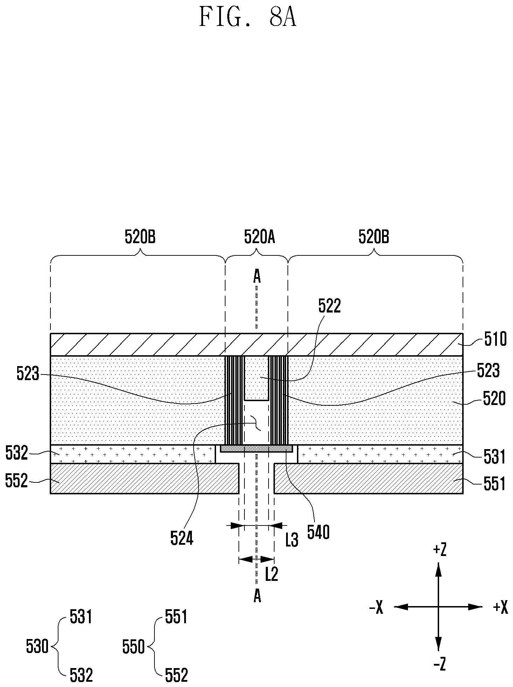

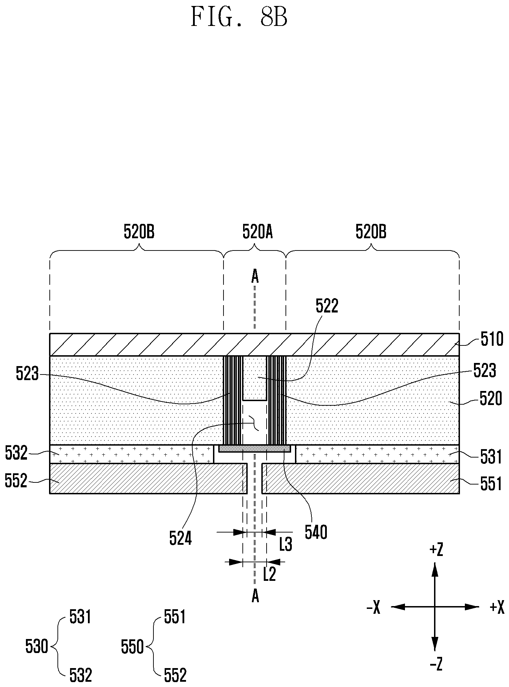

FIG. 8A is a view illustrating a state in which one surface of the support plate 520 constituting the display module 500 according to various embodiments disclosed herein is removed. FIG. 8B is a view illustrating a state in which one surface of the support plate 520 constituting the display module 500 is removed in an embodiment different from FIG. 8A.

According to various embodiments, the surface of the support plate 520 facing the reinforcement plate 550 (e.g., the surface oriented in the -Z direction with reference to FIG. 8A) may be at least partially removed. Referring to FIG. 8A, the surface of the second region 522 of the first portion 520A of the support plate 520 facing the reinforcement plate 550 may be at least partially removed. In an embodiment, a removal region 524 formed in the second region 522 of the support plate 520 may be a region removed from the second region 522 in the surface facing the reinforcement plate 550 through a process such as laser processing or etching.

According to various embodiments, the second region 522 of the first portion 520A of the support plate 520 may have a wider interval in the first direction (e.g., the X-axis direction with reference to FIG. 8A) that the first region 521. In addition, referring to FIG. 8A, the center of the second region 522 of the support plate 520 may be aligned with the folding axis A-A of the electronic device 200, and may be located to be included between the first reinforcement plate 551 and the second reinforcement plate 552 when the electronic device 200 is viewed from the front side (e.g., in the direction of the -Z direction with reference to FIG. 8A). In this case, as the interval of the second region 522, of which the center is aligned with the folding axis A-A, in the first direction becomes wider, the flexibility of the first portion 520A of the support plate 520 may decrease. In addition, as the second width L2 in the second region 522 of the support plate 520 becomes wider, the folding stress that interrupts the folding operation of the support plate 520 may increase. Accordingly, the folding operation of the display module 500 (e.g., the support plate 520) may be interrupted. In various embodiments disclosed herein, the surface of the second region 522 of the support plate 520 facing the reinforcement plate 550 may be partially removed. In this case, flexibility of the second region 522 of the support plate 520 may be increased. In addition, the folding stress that may occur in the second region 522 of the support plate 520 according to the folding operation of the electronic device 200 may be reduced. Accordingly, the support plate 520 may be smoothly folded in response to the folding operation of the electronic device 200.

According to various embodiments, as illustrated in FIG. 8B, the second width L2 of the second region 522 of the support plate 520 may be wider than the interval L3 between the first reinforcement plate 551 and the second reinforcement plate 552. As the second width L2 of the second region 522 of the support plate 520 becomes wider, the area where the support plate 520 supports the display panel 510 may increase. For example, when the electronic device 200 is in the folded state, the display panel 510 may be folded together with the electronic device 200. The display panel 510 may sag in the folded section. When viewed from the front surface of the electronic device 200, the second region 522 of the support plate 520 may be located to correspond to the folded section of the display panel 510 and support the folded (transformed) section of the display panel 510. As the second width L2 of the second region 522 of the support plate 520 is wider than the interval of the reinforcement plates 550, the area supporting the transformed section of the display panel 510 may increase. Accordingly, the phenomenon in which the display panel 510 sags when the electronic device 200 is folded may be improved.

Meanwhile, as described above, as the interval of the second regions 522, of which the center is aligned with the folding axis A-A, in the first direction becomes wider, the flexibility of the first portion 520A of the support plate 520 may decrease. In addition, as the second width L2 in the second region 522 of the support plate 520 becomes wider, the folding stress that interrupts the folding operation of the support plate 520 may increase. Accordingly, the support plate 520 may not be smoothly folded in response to the folding operation of the electronic device 200. In various embodiments disclosed herein, the surface of the second region 522 of the support plate 520 facing the reinforcement plate 550 may be partially removed. In this case, even if the second width L2 of the second region 522 of the support plate 520 is wider than the interval L3 between the reinforcing plates 550, a certain level of flexibility may be ensured through the removal region 524 provided in the second region 522. In addition, the folding stress that may occur in the second region 522 of the support plate 520 according to the folding operation of the electronic device 200 may be reduced. Accordingly, the support plate 520 may be smoothly folded in response to the folding operation of the electronic device 200.

However, as illustrated in FIGS. 8A and 8B, it is not necessarily limited to the case where a portion of the second region 522 can be removed only when the second region 522 of the support plate 520 is located between the reinforcement plates 550. Although not illustrated in the drawings, as illustrated in FIGS. 6A and 6B, even when the second region 522 of the support plate 520 overlaps the first reinforcement plate 551 and/or the second reinforcement plate 552 when the support plate 520 is viewed from the front surface of the electronic device 200, the surface of the second region 522 of the support plate 520 may be removed. Accordingly, the support plate 520 may be smoothly folded in response to the folding operation of the electronic device 200.

According to various embodiments disclosed herein, an electronic device 200 may include a first housing 210, a second housing 220 rotatably connected to the first housing, a display panel 510 a portion of which is transformed by rotation of the second housing relative to the first housing, a support plate 520 disposed below the display panel (e.g., the -Z direction with reference to FIG. 5A) to support the display panel and including a region where the display panel is transformed, wherein the support plate includes a first portion 510A including multiple openings 523 which are arranged at predetermined intervals, and a second portion 520B excluding the first portion, a first reinforcement plate 551 disposed below the support plate and disposed in the first housing such that at least a portion thereof is located in the first portion, and a second reinforcement plate 552 disposed below the support plate and disposed in the second housing such that at least a portion thereof is located in the first portion. The first portion of the support plate may include a first region 521 in which the interval between the openings in a first direction (e.g., the X-axis direction with reference to FIG. 5B) is a first width L1, and a second region 522 in which the interval between the openings in the first direction is a second width L2 greater than the first width, wherein at least a portion of the second region is located between the first reinforcement plate and the second reinforcement plate.

In addition, the second region of the support plate may be located between the first reinforcement plate and the second reinforcement plate when viewed from the front surface of the electronic device (e.g., in the -Z direction with reference to FIG. 5A).

In addition, the center of the second region of the support plate may be aligned with a folding axis A-A of the electronic device when viewed from the front surface of the electronic device.

In addition, the second width in the second region of the support plate may be smaller than a third width L3, which is an interval between the first reinforcement plate and the second reinforcement plate in the first direction.

In addition, the second width in the second region of the support plate may be wider than a third width L3, which is an interval between the first reinforcement plate and the second reinforcement plate in the first direction.

In addition, the second region of the support plate may overlap each of one end of the first reinforcement plate and one end of the second reinforcement plate when the support plate is viewed from the front surface of the electronic device.

In addition, in the second region of the support plate, at least a portion of the surface facing the first reinforcement plate and the second reinforcement plate may be removed.

In addition, the first portion of the support plate may include a first section 611 corresponding to the first reinforcement plate and the second reinforcement plate and a second section 612 located between the first reinforcement plate and the second reinforcement plate, the first section may include a first pattern including multiple openings, and the second section may include a second pattern including multiple openings.

In addition, the first portion of the support plate may include a first section 611 corresponding to the first reinforcement plate and the second reinforcement plate and a second section 612 located between the first reinforcement plate and the second reinforcement plate, and the length (e.g., Y2 in FIG. 6B) of openings, which are located in the second section, in the second direction is shorter than the length (e.g., Y1 in FIG. 6B) of openings, which are located in the first section, in the second direction.

In addition, the first portion of the support plate may include a first section 611 corresponding to the first reinforcement plate and the second reinforcement plate and a second section 612 located between the first reinforcement plate and the second reinforcement plate, and the length of openings, which are located in the second section, in the first direction (e.g., the X-axis direction with reference to FIG. 6B) is shorter than the length of openings, which are located in the first section, in the first direction.

According to various embodiments disclosed herein, a display module 500 included in an electronic device 200 including a first housing 210 and a second housing 220, which are rotatably coupled to each other may include a display panel 510 a portion of which is transformed by rotation of the second housing relative to the first housing, a support plate 520 disposed below the display panel to support the display panel and including a region where the display panel is transformed, wherein the support plate includes a first portion 520A including multiple openings 523 which are arranged at predetermined intervals, and a second portion 520B excluding the first portion 520A, a first reinforcement plate 551 disposed below the support plate and disposed in the first housing such that at least a portion thereof is located in the first portion, and a second reinforcement plate 552 disposed below the support plate and disposed in the second housing such that at least a portion thereof is located in the first portion. The first portion of the support plate may include a first region 521 in which the interval between the openings in a first direction (e.g., the X-axis direction with reference to FIG. 5B) is a first width L1, and a second region 522 in which the interval between the openings in the first direction is a second width L2 greater than the first width, wherein at least a portion of the second region is located between the first reinforcement plate and the second reinforcement plate.

In addition, the second region of the support plate may be located between the first reinforcement plate and the second reinforcement plate when viewed from the front surface of the electronic device (e.g., in the -Z direction with reference to FIG. 5A).

In addition, the center of the second region of the support plate may be aligned with a folding axis A-A of the electronic device when viewed from the front surface of the electronic device.

In addition, the second width in the second region of the support plate may be smaller than a third width L3, which is an interval between the first reinforcement plate and the second reinforcement plate in the first direction.

In addition, the second width in the second region of the support plate may be wider than a third width L3, which is an interval between the first reinforcement plate and the second reinforcement plate in the first direction.

In addition, the second region of the support plate may overlap each of one end of the first reinforcement plate and one end of the second reinforcement plate when the support plate is viewed from the front surface of the electronic device.

In addition, in the second region of the support plate, at least a portion of the surface facing the first reinforcement plate and the second reinforcement plate may be removed.

In addition, the first portion of the support plate may include a first section 611 corresponding to the first reinforcement plate and the second reinforcement plate, and a second section 612 located between the first reinforcement plate and the second reinforcement plate. The first section may include a first pattern including multiple openings, and the second section may include a second pattern including multiple openings.

In addition, the first portion of the support plate may include a first section 611 corresponding to the first reinforcement plate and the second reinforcement plate, and a second section 612 located between the first reinforcement plate and the second reinforcement plate, and the length Y2 of openings, which are located in the second section, in the second direction may be shorter than the length Y1 of openings, which are located in the first section, in the second direction.

In addition, the first portion of the support plate may include a first section 611 corresponding to the first reinforcement plate and the second reinforcement plate, and a second section 612 located between the first reinforcement plate and the second reinforcement plate, and the length of openings, which are located in the second section, in the first direction (e.g., the X-axis direction with reference to FIG. 6B) may be shorter than the length of openings, which are located in the first section, in the first direction.

The embodiments of the disclosure described and shown in the specification and the drawings are merely specific examples that have been presented to easily explain the technical contents of embodiments of the disclosure and help understanding of embodiments of the disclosure, and are not intended to limit the scope of embodiments of the disclosure. Therefore, the scope of various embodiments of the disclosure should be construed to include, in addition to the embodiments set forth herein, all changes and modifications derived based on the technical idea of various embodiments of the disclosure.

## Claims

1. An electronic device comprising:
a first housing;
a second housing rotatably connected to the first housing;
a display panel a portion of which is transformed by rotation of the second housing relative to the first housing;
a support plate disposed below the display panel to support the display panel and comprising a region where the display panel is transformed, wherein the support plate comprises a first portion comprising multiple openings which are arranged at predetermined intervals, and a second portion excluding the first portion;
a first reinforcement plate disposed below the support plate and disposed in the first housing such that at least a portion thereof is located in the first portion; and
a second reinforcement plate disposed below the support plate and disposed in the second housing such that at least a portion thereof is located in the first portion,
wherein the first portion of the support plate comprises:
a first region in which an width between the openings in a first direction is a first width; and
a second region in which the width between the openings in the first direction is a second width greater than the first width, wherein at least a portion of the second region is located between the first reinforcement plate and the second reinforcement plate.

2. The electronic device of claim 1, wherein the second region of the support plate is located between the first reinforcement plate and the second reinforcement plate when viewed from a front surface of the electronic device.

3. The electronic device of claim 2, wherein a center of the second region of the support plate is aligned with a folding axis of the electronic device when viewed from the front surface of the electronic device.

4. The electronic device of claim 1, wherein the second width in the second region of the support plate is smaller than a third width, which is an width between the first reinforcement plate and the second reinforcement plate in the first direction.

5. The electronic device of claim 1, wherein the second width in the second region of the support plate is greater than a third width, which is an width between the first reinforcement plate and the second reinforcement plate in the first direction.

6. The electronic device of claim 1, wherein the second region of the support plate overlaps each of one end of the first reinforcement plate and one end of the second reinforcement plate when viewed from the front surface of the electronic device.

7. The electronic device of claim 1, wherein, in the second region of the support plate, at least a portion of a surface facing the first reinforcement plate and the second reinforcement plate is removed.

8. The electronic device of claim 1, wherein the first portion of the support plate comprises a first section corresponding to the first reinforcement plate and the second reinforcement plate and a second section located between the first reinforcement plate and the second reinforcement plate,
wherein the first section comprises a first pattern comprising multiple openings, and
wherein the second section comprises a second pattern comprising multiple openings.

9. The electronic device of claim 1, wherein the first portion of the support plate comprises a first section corresponding to the first reinforcement plate and the second reinforcement plate and a second section located between the first reinforcement plate and the second reinforcement plate, and
wherein a length of openings, which are located in the second section, in a second direction is shorter than a length of openings, which are located in the first section, in the second direction.

10. The electronic device of claim 1, wherein the first portion of the support plate comprises a first section corresponding to the first reinforcement plate and the second reinforcement plate and a second section located between the first reinforcement plate and the second reinforcement plate, and
wherein a length of openings, which are located in the second section, in the first direction is shorter than a length of openings, which are located in the first section, in the first direction.

11. A display module included in an electronic device comprising a first housing and a second housing which are rotatably connected to each other, the display module comprising:
a display panel a portion of which is transformed by rotation of the second housing relative to the first housing;
a support plate disposed below the display panel to support the display panel and comprising a region where the display panel is transformed, wherein the support plate comprises a first portion comprising multiple openings which are arranged at predetermined intervals, and a second portion excluding the first portion;
a first reinforcement plate disposed below the support plate and disposed in the first housing such that at least a portion thereof is located in the first portion; and
a second reinforcement plate disposed below the support plate and disposed in the second housing such that at least a portion thereof is located in the first portion,
wherein the first portion of the support plate comprises:
a first region in which an width between the openings in a first direction is a first width; and
a second region in which the width between the openings in the first direction is a second width greater than the first width, wherein at least a portion of the second region is located between the first reinforcement plate and the second reinforcement plate.

12. The display module of claim 11, wherein the second region of the support plate is located between the first reinforcement plate and the second reinforcement plate when viewed from a front surface of the electronic device, and
wherein a center of the second region of the support plate is aligned with a folding axis of the electronic device when viewed from the front surface of the electronic device.

13. The display module of claim 11, wherein the second width in the second region of the support plate is smaller than a third width, which is an width between the first reinforcement plate and the second reinforcement plate in the first direction.

14. The display module of claim 11, wherein the second width in the second region of the support plate is greater than a third width, which is an width between the first reinforcement plate and the second reinforcement plate in the first direction.

15. The display module of claim 11, wherein the second region of the support plate overlaps each of one end of the first reinforcement plate and one end of the second reinforcement plate when viewed from the front surface of the electronic device.
